# EUROPEAN PATENT APPLICATION

(11) **EP 1 282 164 A2**
(43) Date of publication of application: **05.02.2003**
(21) Application number: 02102084.7
(22) Date of filing: 01.08.2002
(51) Int. Cl.: H01L 21/768

(54) **Method to improve the adhesion of dielectric layers to copper**

(30) Priority: 01.08.2001 US 920578
(71) Applicant: Texas Instruments Incorporated, Dallas, Texas 75251 (US)
(72) Inventor: Tsui, Tink, Dallas, Texas 75320 (US)
(74) Representative: Holt, Michael

(57) **Abstract**

The invention describes a method for forming an adhesive layer on copper. A copper layer (120) is formed as part of the metal interconnect structure of an integrated circuit. An adhesive layer (130) is formed on the copper layer (120) and a second layer (140) is formed on the adhesive layer (130). Any number of dielectric layers or non-dielectric layers are then formed over the second layer (140).

## Description

### FIELD OF THE INVENTION

The invention is generally related to the field of semiconductor devices and fabrication and more specifically to a method for forming a copper interconnect structure.

### BACKGROUND OF THE INVENTION

To increase the operating speed, high performance integrated circuits use copper interconnect technology along with low dielectric constant dielectrics. Currently the damascene method is the most widely used method for forming copper interconnects. A typical damascene process is illustrated in Figures 1(a) - 1(c).

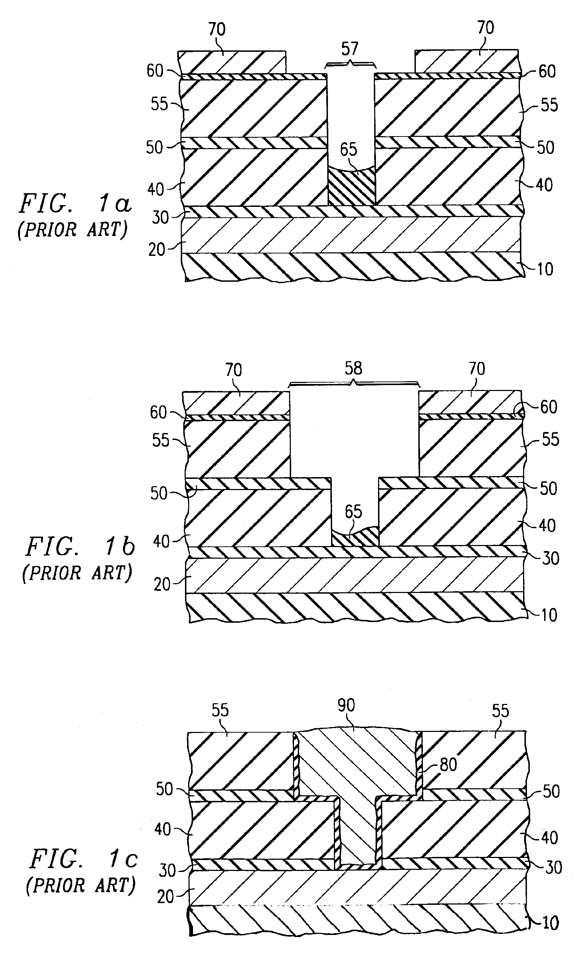

A silicon nitride (SiN) etch stop layer 30 is formed over a dielectric layer 10 and a copper line 20. Silicon nitride is currently the most commonly used etch stop layer material. Silicon nitride is generally transparent to UV radiation which is used to program and/or erase any flash memory cells on the silicon wafer. It is therefore necessary the any material used to form the barrier layer be transparent to UV radiation on integrated circuits that contain flash memory devices. A dielectric layer 40, a second etch stop layer 50, and a second dielectric layer 55 are formed over the etch stop layer 30. A patterned layer of photoresist is then formed and used to pattern the etching of the first trench 57. Following the etching of the first trench 57, a backside anti-reflective coating (BARC) layer 60 is formed followed by a second patterned photoresist layer 70. During the formation of the BARC layer 60, additional BARC material 65 is formed in the trench 57. The additional BARC material 65 is necessary to protect the bottom surface of the trench during the etching of the second trench 58. This is illustrated in Figure 1(b) where a portion of the additional BARC 65 is removed during the etching process. Following the etching of the second trench 58, a trench liner material is formed 80 and copper 90 is used to fill both trenches as illustrated in Figure 1(c).

As illustrated in Figure 1(c) the SiN layer 30 can be left covering the underlying copper layer over large regions of the semiconductor substrate. It is therefore important that there be a strong adhesion between the SiN layer and the underlying copper layer. Typically the adhesion between SiN and copper is on the order of 10 J/m² as measured by a 4-point bend adhesion technique. This is a measure of the energy required to separate the layers. During the processing required to complete the integrated circuit some amount of copper and SiN delamination 100 can occur as illustrated in Figure 1(d). This delamination can lead to a reduction in the functionality of the integrated circuit. There is therefore a need for a method to increase the adhesion between the copper and the SiN layers.

### SUMMARY OF THE INVENTION

The instant describes a method for improving the adhesion of dielectric layers to copper. A silicon carbide film is formed on a layer of copper. The silicon carbide film is transparent to UV radiation making it suitable for use on integrated circuits containing flash memory cells. A silicon nitride etch stop layer is then formed on the silicon carbide film. The silicon nitride layer will function as an etch stop layer during integrated circuit processing and the silicon carbide film will improve the adhesion of the silicon nitride layer to the underlying copper layer.

### BRIEF DESCRIPTION OF THE DRAWINGS

In the drawings:
FIGURES 1(a) - 1(d) are cross-sectional diagrams illustrating the prior art.
FIGURES 2(a) - 2(b) are cross-sectional diagrams illustrating an embodiment of the instant invention.

### DETAILED DESCRIPTION OF THE INVENTION

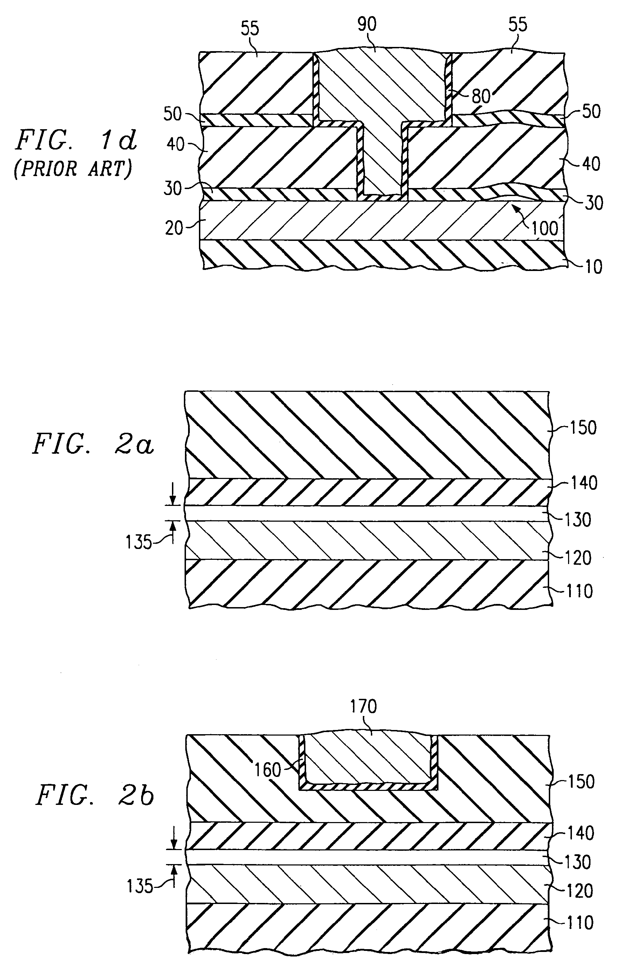

The invention will now be described with reference to Figures 2(a) and 2(b). It will be apparent to those of ordinary skill in the art that the benefits of the invention can be applied to other structures where a layer over a copper layer is required.

The requirement of higher clock rates has lead to the use of copper to form the metal interconnect lines in integrated circuits. In addition to the use of copper, dielectric layers such as organosilicate glass (OSG) (dielectric constant ∼2.6) and florosilicate glass (FSG) are currently being used to take advantage of the lower dielectric constant of such materials compared to silicon dioxide. In an embodiment of the instant invention, an adhesion layer (or glue layer) is first formed over a copper layer. The copper layer may be part of the copper interconnect structure of an integrated circuit. As shown in figure 2(a) such a copper layer 120 can be formed over a dielectric layer 110. The dielectric layer is typically formed over a silicon substrate which contains numerous electronic devices such as transistors, diodes, capacitors, etc. Following the formation of these electronic devices in the silicon substrate various dielectric layers and metal layers are formed above the silicon substrate to form the metal interconnect structures used to interconnect the various electronic devices on the substrate. As shown in figure 2(a) an adhesion layer (or glue layer) 130 is formed on the copper layer 120. In an embodiment of the instant invention the adhesion layer 130 comprises silicon carbide (SiC). The SiC adhesion layer 130 can be formed using any number of techniques including plasma enhanced chemical vapor deposition using trimethylsilane or tetramethylsilane at temperatures of 250°C to 500°C and more preferably 350°C to 400°C. Ultra violet (UV) radiation ( i.e., light with wavelengths between 220nm - 400nm) is often used to program/erase flash memory cells on integrated circuits. Therefore any adhesive used on these integrated circuits must be transparent to UV radiation. To enable UV radiation to penetrate the SiC adhesion layer 130, the thickness of the layer 135 must be less than 200A. In a further embodiment of the instant invention the thickness of the SiC adhesion layer 130 is between 25A and 150A. For a SiC layer on copper the adhesion is typically 17 - 20 J/m². In an embodiment of the instant invention the composition of the SiC film comprises silicon, carbon, hydrogen, and oxygen with concentrations of approximately 30 atomic percent, 30 atomic percent, 30 atomic percent, and 10 atomic percent respectively. Following the formation of the SiC adhesion layer 130, a second layer 140 is formed on the adhesion layer. In most instances this second layer 140 will function as an etch stop layer. In an embodiment of the instant invention the second layer 140 will comprise silicon nitride (SiN) or other suitable materials. In the case of a SiN etch stop layer 140, the SiN layer can be formed in-situ in the same processing chamber in which the SiC adhesion layer 130 is formed. In-situ formation of the SiN layer eliminates the need to expose the SiC surface to the ambient of the fabrication facility. Following the formation of the etch stop layer 140 a dielectric layer 150 is formed. In an embodiment of the instant invention this dielectric layer 150 comprises silicon oxide, OSG, FSG, or any suitable dielectric material. In further embodiments of the instant invention any number of dielectric or non-dielectric layers can be formed above the second layer 120.

Shown in Figure 2(b) is a copper structure 170 formed in the dielectric layer 150 for an embodiment of the instant invention. The copper structure 170 is formed by first forming a trench in the dielectric layer using various photolithography and etching processes. Following the formation of the trench, a trench liner film 160 is formed in the trench followed by the deposition of a thick copper layer. Chemical mechanical polishing (CMP) is then used to remove the excess copper and liner material. In other embodiments the copper structure will extend through the dielectric layer 150, the etch stop layer 140, and the adhesion layer 130 and contact the underlying copper layer 120. In a further embodiment a dual damascene process can be used to form the copper structure 90 illustrated in Figure 1(c).

While this invention has been described with reference to illustrative embodiments, this description is not intended to be construed in a limiting sense. Various modifications and combinations of the illustrative embodiments, as well as other embodiments of the invention will be apparent to persons skilled in the art upon reference to the description. It is therefore intended that the appended claims encompass any such modifications or embodiments.

## Claims

1. A method for forming an adhesion layer on copper, comprising:
providing a copper layer on an integrated circuit; forming an adhesive layer on said copper layer wherein said adhesive layer is transparent to UV radiation; and
forming an etch stop layer on said adhesive layer.

2. The method of claim 1 wherein said adhesive layer comprises silicon carbide.

3. The method of claim 2 wherein said etch stop layer comprises silicon nitride.

4. The method of claim 2 wherein said silicon carbide layer is less than 200A thick.

5. A method for forming a copper interconnect structure on an integrated circuit, comprising:
providing a copper layer over a semiconductor substrate wherein said semiconductor substrate comprises electronic devices;
forming an adhesive layer on said copper layer wherein said adhesive layer is transparent to UV radiation; forming an etch stop layer on said adhesive layer; forming at least one dielectric layer on said etch stop layer; and
forming a copper structure in said dielectric layer.

6. The method of claim 5 wherein said adhesive layer comprises silicon carbide.

7. The method of claim 6 wherein said etch stop layer comprises silicon nitride.

8. The method of claim 6 wherein said silicon carbide layer is less than 200A thick.

9. The method of claim 5 wherein said dielectric layer is a material selected from the group consisting of OSG and FSG.

10. The method of any of claims 5 to 9 wherein said forming said copper structure in said dielectric layer comprises:
forming a trench in said dielectric layer;
forming a liner film in said trench;
forming a thick copper layer in said trench; and
removing excess copper using chemical mechanical polishing.
